# EUROPEAN PATENT SPECIFICATION

(11) **EP 1 803 554 B1**
(45) Date of publication and mention of the grant of the patent: **22.04.2009**
(21) Application number: 06025144.4
(22) Date of filing: 05.12.2006
(51) Int. Cl.: B41C 1/10, B41F 31/04

(54) **Developing method, and printing machine for executing the developing method**
Entwicklungsverfahren und Druckmaschine zum Ausführen des Entwicklungsverfahrens
Procédé de développement, et machine d'impression pour l'exécution de développement

(30) Priority: 27.12.2005 JP 2005374730
(43) Date of publication of application: 04.07.2007
(73) Proprietor: Dainippon Screen Mfg., Co., Ltd., Kyoto 602-8585 (JP)
(72) Inventor: Yamamoto,Takaharu, c/o Dainippon Screen Mfg. Co., Ltd., Horikawa-dori Kamikyo-ku Kyoto 602-8585 (JP); Fukui, Kazuki, c/o Dainippon Screen Mfg. Co., Ltd., Horikawa-dori Kamikyo-ku Kyoto 602-8585 (JP)
(74) Representative: Kilian, Helmut

(56) References cited:
- EP-A- 1 527 875
- EP-A- 1 566 270
- EP-A1- 0 668 162
- EP-A1- 1 232 859
- EP-A2- 1 462 249

## Description

### BACKGROUND OF THE INVENTION

### 1. Field of the Invention

This invention relates to a developing method and a printing machine for executing this developing method.

### 2. Description of the Related Art

As described in Japanese Unexamined Patent Publication H9-123387 (1997), for example, a printing machine has been developed which includes a platemaking mechanism so that the single printing machine performs from a prepress process to a printing process. Such a printing machine has a developing device mounted therein.

As described in Japanese Unexamined Patent Publications No. 2000-141933, No. 2005-14294, EP 1 527 875 A1, and EP 1 566 270 A1, printing plates of the type generally called chemicalless printing plates have been proposed in recent years, which are developed, without using a developer, by removing non-image areas from the printing plates having images recorded thereon, using dampening water and ink. When such chemicalless printing plates are used, a developing process may be carried out using the dampening water feeders and ink feeders which are intrinsic parts of a printing machine, without requiring a dedicated developing device.

With a printing plate "Agfa Thermolite" manufactured by Agfa Co., for example, a dampening water feed roller is placed in contact with the printing plate to soften non-image areas with dampening water, and thereafter an ink roller is placed in contact to remove the non-image areas.

A printing machine includes an ink feeder having ink rollers for feeding ink to the surface of a printing plate. The ink feeder has a plurality of ink keys arranged axially of one of the ink rollers. These ink keys are divided in the direction of width of printing paper, and arranged to correspond to a plurality of regions. Each ink key has an adjustable degree of opening relative to the peripheral surface of the ink roller.

In time of printing, the opening of each ink key is set in proportion to an image percentage of a corresponding region. That is, the larger the image percentage is, to the greater degree the ink key is opened.

On the other hand, in time of development, the opening of each ink key is made the same as that in time of printing, or all the ink keys are opened to the same degree. However, it has been found that, depending on printing conditions (e.g. the type of ink), non-image areas remain in regions of small image percentage, and it takes time to remove such areas. Sometimes the developing process is not performed with sufficient accuracy.

### SUMMARY OF THE INVENTION

The object of this invention, therefore, is to provide a developing method and a printing machine capable of performing a developing process with increased accuracy when developing printing plates by using dampening water and ink.

The above object is fulfilled, according to the present invention, by a printing plate developing method for removing non-image areas from a printing plate having an image recorded thereon, by using a printing machine having an image recorder for recording the image on the printing plate, ink rollers for feeding ink to a surface of the printing plate, and dampening water rollers for feeding dampening water to the surface of the printing plate, the developing method comprising an image recording step for recording the image on the printing plate with the image recorder; an ink key opening degree setting step for setting opening degrees of ink keys for feeding the ink to the ink rollers, such that the larger opening degree is set for the smaller image percentage in regions, corresponding to the respective ink keys, on the printing plate having the image recorded thereon; a preliminary ink feeding step for feeding the ink to the ink rollers; an ink transfer step for transferring the ink from the ink rollers to the dampening water rollers; a dampening water feeding step for feeding the dampening water to the printing plate with the dampening water rollers to render the non-image areas on the printing plate easily removable; an ink feeding step for feeding the ink to the printing plate with the ink rollers based on the ink key opening degrees set in the ink key opening degree setting step, to remove the non-image areas; and a transfer step for transferring the ink used to remove the non-image areas, from the printing plate to printing paper.

With this developing method, a developing process may be carried out with increased accuracy when the printing plate is developed by using dampening water and ink.

In another aspect of the invention, there is provided a printing machine having an ink roller for feeding ink to a surface of a printing plate, ink keys capable of feeding desired quantities of ink to a plurality of regions on the ink roller, and a dampening water feeding device for feeding dampening water to the surface of the printing plate, the printing machine comprising an input device for inputting information indicating whether the printing plate is a first printing plate that permits non-image areas to be removed therefrom with the ink, or a second printing plate that prohibits non-image areas from being removed with the ink; an ink key opening degree setting device for setting the larger opening degree of the ink keys for the smaller image percentage of an image recorded on the printing plate when the printing plate set to the printing machine is the first printing plate, and setting the larger opening degree of the ink keys for the larger image percentage of the image recorded on the printing plate when the printing plate set to the printing machine is the second printing plate; and a pre-inking operation executing device for executing a pre-inking operation for feeding the ink to the printing plate based on an ink quantity set by the ink key opening degree setting device, while dampening water is fed to the printing plate by the dampening water feeding device before a printing operation.

With this printing machine, a developing process may be carried out with increased accuracy when a chemicalless printing plate is used as printing plate.

Other features and advantages of the invention will be apparent from the following detailed description of the embodiments of the invention.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
Fig. 1 is a schematic view of a printing machine according to this invention;
Fig. 2 is a schematic side view showing a principal portion of an ink feeder;
Fig. 3 is a plan view showing a principal portion of the ink feeder;
Fig. 4 is a schematic side view of a dampening water feeder;
Fig. 5 is a perspective view showing a roller drive mechanism of the dampening water feeder;
Fig. 6 is a perspective view showing the roller drive mechanism of the dampening water feeder;
Fig. 7 is a perspective view showing the roller drive mechanism of the dampening water feeder;
Fig. 8 is a block diagram showing a principal electrical structure of the printing machine.
Fig. 9 is a flow chart of a procedure of executing a developing method according to this invention;
Fig. 10 is a flow chart of the developing method according to this invention;
Fig. 11 is a schematic view showing a developing operation according to this invention;
Fig. 12 is a schematic view showing the developing operation according to this invention;
Fig. 13 is a schematic view showing the developing operation according to this invention;
Fig. 14 is a schematic view showing the developing operation according to this invention;
Fig. 15A is a graph showing a relationship between image percentage and opening degree of ink keys;
Fig. 15B is a graph showing a relationship between image percentage and opening degree of the ink keys;
Fig. 16A is a graph showing a relationship between image percentage and opening degree of the ink keys; and
Fig. 16B is a graph showing a relationship between image percentage and opening degree of the ink keys.

### DESCRIPTION OF THE PREFERRED EMBODIMENTS

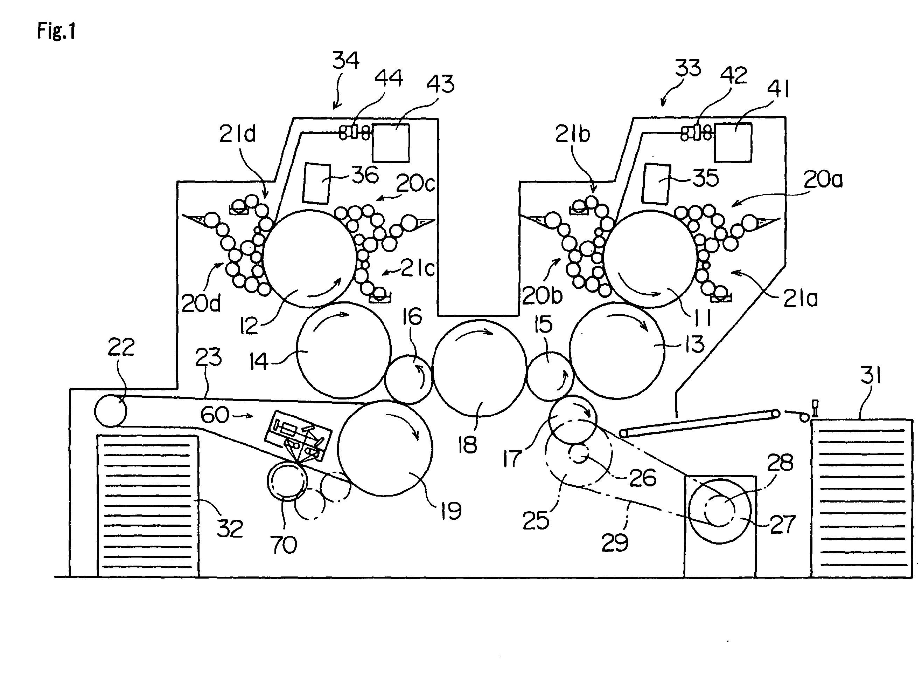

An embodiment of this invention will be described hereinafter with reference to the drawings. The construction of a printing machine according to this invention will be described first. Fig. 1 is a schematic view of the printing machine according to this invention.

This printing machine records images on blank plates mounted on first and second plate cylinders 11 and 12 in a prepress process, feeds inks to the plates having the images recorded thereon, and transfers the inks from the plates through first and second blanket cylinders 13 and 14 to printing paper held on first and second impression cylinders 15 and 16, thereby printing the images in four colors on the printing paper.

The printing machine has the first plate cylinder 11, the second plate cylinder 12, the first blanket cylinder 13 contactable with the first plate cylinder 11, the second blanket cylinder 14 contactable with the second plate cylinder 12, the first impression cylinder 15 contactable with the first blanket cylinder 13, and the second impression cylinder 16 contactable with the second blanket cylinder 14. The printing machine further includes a paper feed cylinder 17 for transferring printing paper fed from a paper storage station 31 to the first impression cylinder 15, a transfer cylinder 18 for transferring the printing paper from the first impression cylinder 15 to the second impression cylinder 16, a paper discharge cylinder 19 with chains 23 wound thereon and extending to and wound on sprockets 22 for discharging printed paper from the second impression cylinder 16 to a paper discharge station 32, and an image pickup station 60 for reading images and measuring densities of detecting patches printed on the printing paper passing over a suction roller 70.

Each of the first and second plate cylinders 11 and 12 is what is called a two-segmented cylinder for holding two printing plates peripherally thereof for printing in two different colors. The first and second blanket cylinders 13 and 14 have the same diameter as the first and second plate cylinders 11 and 12, and each has blanket surfaces for transferring images in two colors.

The first and second impression cylinders 15 and 16 movable into contact with the first and second blanket cylinders 13 and 14, respectively, have half the diameter of the first and second plate cylinders 11 and 12 and the first and second blanket cylinders 13 and 14. The first and second impression cylinders 15 and 16 have grippers, not shown, for holding and transporting the forward end of printing paper.

The paper feed cylinder 17 disposed adjacent the impression cylinder 15 has the same diameter as the first and second impression cylinders 15 and 16. The paper feed cylinder 17 has a gripper, not shown, for holding and transporting, with each intermittent rotation of the feed cylinder 17, the forward end of each sheet of printing paper fed from the paper storage station 31. When the printing paper is transferred from the feed cylinder 17 to the first impression cylinder 15, the gripper of the first impression cylinder 15 holds the forward end of the printing paper which has been held by the gripper of the feed cylinder 17.

The transfer cylinder 18 disposed between the first impression cylinder 15 and second impression cylinder 16 has the same diameter as the first and second plate cylinders 11 and 12 and the first and second blanket cylinders 13 and 14. The transfer cylinder 18 has a gripper, not shown, for holding and transporting the forward end of the printing paper received from the first impression cylinder 15, and transferring the forward end of the printing paper to the gripper of the second impression cylinder 16.

The paper discharge cylinder 19 disposed adjacent the second impression cylinder 16 has the same diameter as the first and second plate cylinders 11 and 12 and the first and second blanket cylinders 13 and 14. The discharge cylinder 19 has a pair of chains 23 wound around opposite ends thereof. The chains 23 are interconnected by coupling members, not shown, having grippers. When the second impression cylinder 16 transfers the printing paper to the discharge cylinder 19, one of the grippers on the discharge cylinder 17 holds the forward end of the printing paper having been held by the gripper of the second impression cylinder 16. With movement of the chains 23, the printing paper is transported to the paper discharge station 32 to be discharged thereon.

The paper feed cylinder 17 has a gear attached to an end thereof and connected to a gear 26 disposed coaxially with a driven pulley 25. A belt 29 is wound around and extends between the driven pulley 25 and a drive pulley 28 rotatable by a drive motor 27. Thus, the paper feed cylinder 17 is rotatable by drive of the motor 27. The first and second plate cylinders 11 and 12, first and second blanket cylinders 13 and 14, first and second impression cylinders 15 and 16, paper feed cylinder 17, transfer cylinder 18 and paper discharge cylinder 19 are coupled to one another by gears attached to ends thereof, respectively. Thus, by the drive of motor 27, the paper feed cylinder 17, first and second impression cylinders 15 and 16, paper discharge cylinder 19, first and second blanket cylinders 13 and 14, first and second plate cylinders 11 and 12 and transfer cylinder 18 are rotatable synchronously with one another.

The first plate cylinder 11 is surrounded by an ink feeder 20a for feeding an ink of black (K), for example, to a plate, an ink feeder 20b for feeding an ink of cyan (C), for example, to a plate, and dampening water feeders 21a and 21b for feeding dampening water to the plates. The second plate cylinder 12 is surrounded by an ink feeder 20c for feeding an ink of magenta (M), for example, to a plate, an ink feeder 20d for feeding an ink of yellow (Y), for example, to a plate, and dampening water feeders 21c and 21d for feeding dampening water to the plates.

Further, arranged around the first and second plate cylinders 11 and 12 are a plate feeder 33 for feeding plates to the peripheral surface of the first plate cylinder 11, a plate feeder 34 for feeding plates to the peripheral surface of the second plate cylinder 12, an image recorder 35 for recording images on the plates mounted peripherally of the first plate cylinder 11, and an image recorder 36 for recording images on the plates mounted peripherally of the second plate cylinder 12.

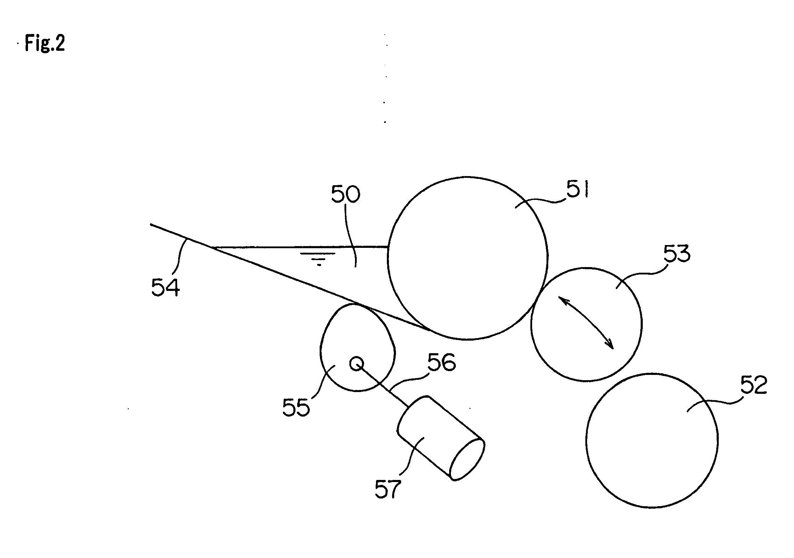

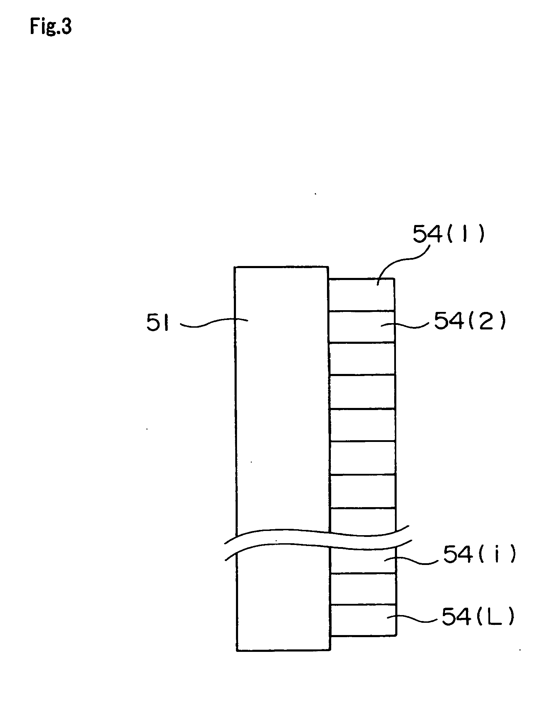

Fig. 2 is a schematic side view showing a principal portion of the ink feeder 20d among the above ink feeders 20a, 20b, 20c and 20d (which may be referred to collectively as "ink feeder 20"). Fig. 3 is a plan view thereof. Ink 50 is omitted from Fig. 3.

The ink feeder 20d includes an ink fountain roller 51 having an axis thereof extending in a direction of width of prints (i.e. perpendicular to a printing direction of the printing machine), a plurality of ink carrier rollers 52 (only one being shown in Fig. 2), an ink transfer roller 53 that vibrates between the ink fountain roller 51 and a foremost one of the ink carrier rollers 52, and ink applicator rollers 59 described hereinafter. The ink feeder 20d further includes ink keys 54 (1), 54 (2) ... 54 (L) (which may be referred to collectively as "ink keys 54") arranged in the direction of width of the prints. The ink fountain roller 51 and ink keys 54 define an ink well for storing ink 50.

In this specification, the ink fountain roller 51, ink carrier rollers 52, ink transfer roller 53 and ink applicator rollers 59 are referred to collectively as "ink rollers".

Eccentric cams 55, L in number, are arranged under the respective ink keys 54 for pressing the ink keys 54 toward the surface of ink fountain roller 51 to vary the opening degree of each ink key 54 with respect to the ink fountain roller 51. The eccentric cams 55 are connected through shafts 56 to pulse motors 57, L in number, for rotating the eccentric cams 55, respectively.

Each pulse motor 57, in response to an ink key drive pulse applied thereto, rotates the eccentric cam 55 about the shaft 56 to vary a pressure applied to the ink key 54. The opening degree of the ink key 54 with respect to the ink fountain roller 51 is thereby varied to vary the rate of ink fed to the printing plate.

The other ink feeders 20a, 20b and 20c have the same construction as this ink feeder 20d.

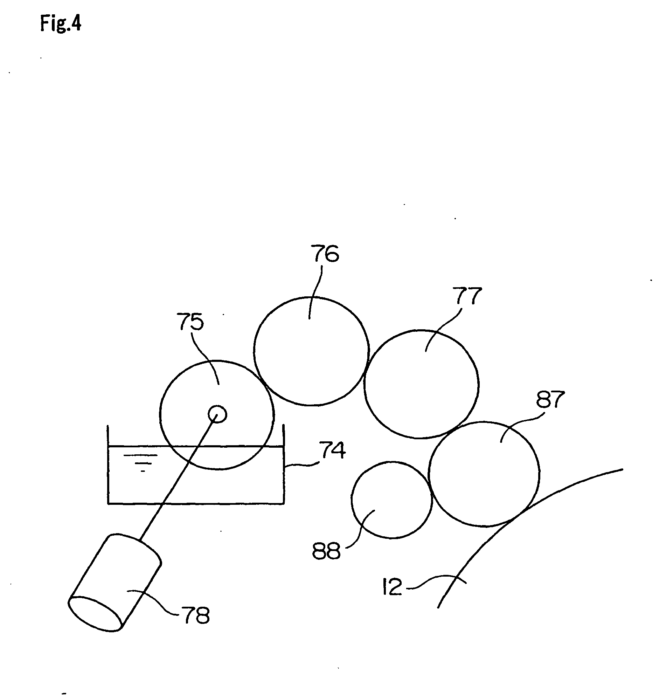

Fig. 4 is a schematic side view showing the dampening water feeder 21d among the above dampening water feeders 21a, 21b, 21c and 21d (which may be referred to collectively as "dampening water feeder 21").

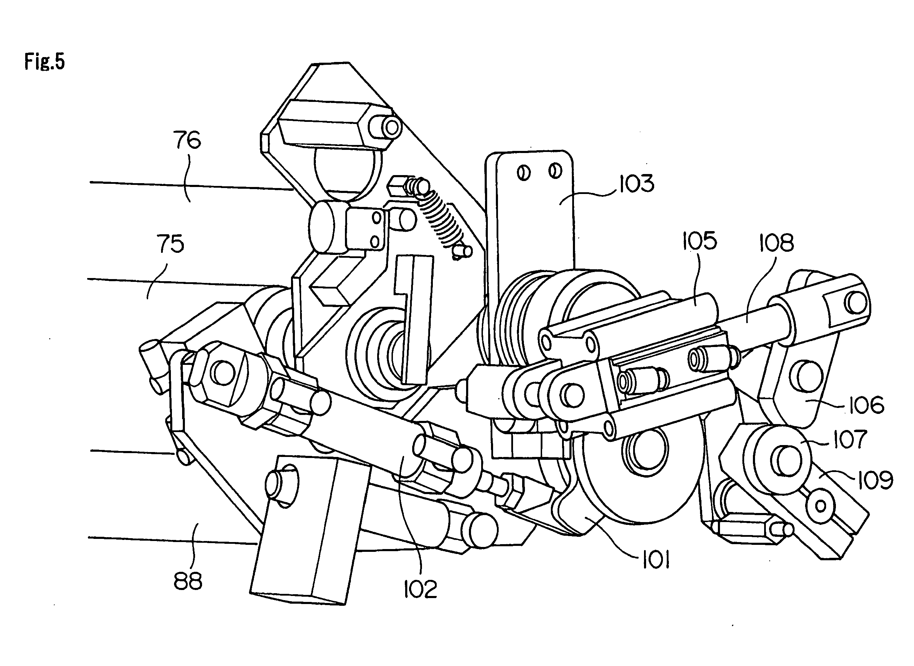

The dampening water feeder 21d includes a water source having a water vessel 74 for storing dampening water and a water fountain roller 75 rotatable by a motor 78, a metering roller 76, an intermediate roller 77, a water applicator roller 87 for transferring the dampening water fed from the water vessel 74 via the fountain roller 75, metering roller 76 and intermediate roller 77 to the surface of one of the plates mounted peripherally of the second plate cylinder 12, and a bridge roller 88 acting as a rider roller for leveling the dampening water on the water applicator roller 87, and capable of bridging the ink applicator rollers 59 described hereinafter and the water applicator roller 87. This dampening water feeder 21d is capable of adjusting the feed rate of dampening water to the surface of the plate by varying the rotating rate of fountain roller 75. Further, this dampening water feeder 21d is capable of moving the water applicator roller 87 into and out of contact with the intermediate roller 77, moving the water applicator roller 87 into and out of contact with the printing plate, and moving the bridge roller 88, while contacting the water applicator roller 87, into and out of contact with one of the ink applicator rollers 59. (These operations will be described hereinafter with reference to Figs. 5 through 7.)

In this specification, the fountain roller 75, metering roller 76, intermediate roller 77, water applicator roller 87 and bridge roller 88 are referred to collectively as "dampening water rollers".

Figs. 5 through 7 are perspective views showing a roller drive mechanism of the dampening water feeder 21d described above. These figures are perspective views of one end of each roller seen from different angles. The other end of each roller has the same construction.

Referring to Figs. 4 through 7, an offset mechanism 101 is disposed at the end of the water applicator roller 87. An air cylinder 102 (Fig. 5) is connected to the offset mechanism 101. The applicator roller 87 is driven by the air cylinder 102 to move between a position for contacting the intermediate roller 77 and a position separated from the intermediate roller 77.

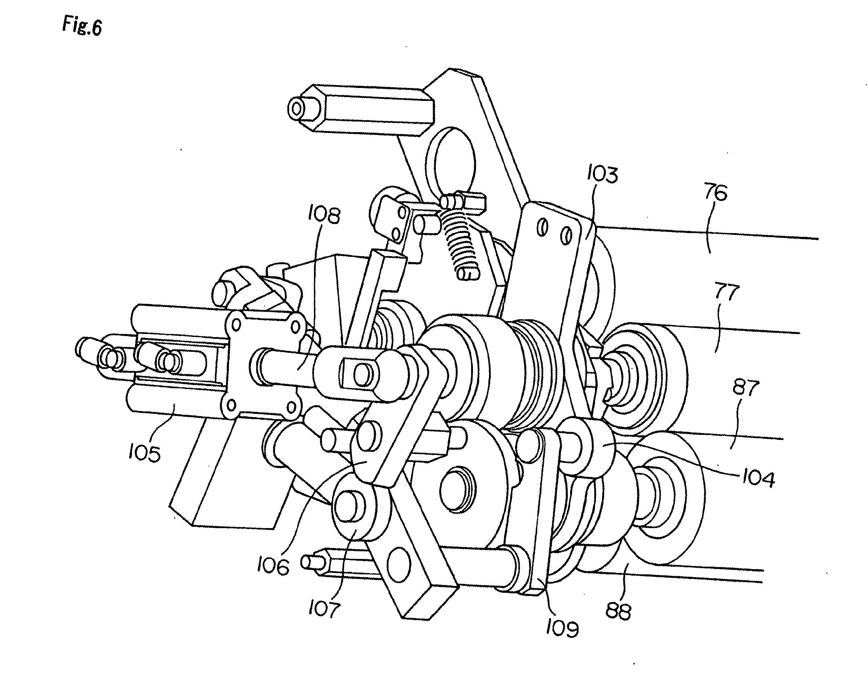

The water applicator roller 87 is supported by a support plate 103 rockable about the axis of intermediate roller 77. The support plate 103 has a cam follower 104 (Fig. 6) which can contact a cam disposed laterally of the second plate cylinder 12. With rotation of the second plate cylinder 12, the cam follower 104 contacts the cam disposed laterally of the second plate cylinder 12, whereby the water applicator roller 87 is movable between a position for contacting both the intermediate roller 77 and the printing plate mounted on the second plate cylinder 12, and a position in contact with the intermediate roller 77 but separated from the second plate cylinder 12.

A lock mechanism is provided for fixing the water applicator roller 87 to the position in contact with the intermediate roller 77 but separated from the second plate cylinder 12. That is, an air cylinder 105 is disposed laterally of the water applicator roller 87, and the air cylinder 105 has a cylinder rod 108 with a rocking arm 106 connected to a forward end thereof. As shown in Figs. 5 and 6, when the cylinder rod 108 of air cylinder 105 is extended, the rocking arm 106 contacts a cam follower 107 connected to the cam follower 104 through an arm 109. In this state, rocking of the arm 109 is restricted, and the water applicator roller 87 is fixed to the position in contact with the intermediate roller 77 but separated from the second plate cylinder 12.

When the cylinder rod 108 of air cylinder 105 is retracted, on the other hand, the rocking arm 106 moves away from the cam follower 107 connected to the cam follower 104 through the arm 109. In this state, the arm 109 is freely rockable. With rotation of the second plate cylinder 12, the cam follower 104 contacts the cam disposed laterally of the second plate cylinder 12. Thus, as described above, the water applicator roller 87 moves between the position for contacting both the intermediate roller 77 and the printing plate mounted on the second plate cylinder 12, and the position in contact with the intermediate roller 77 but separated from the second plate cylinder 12.

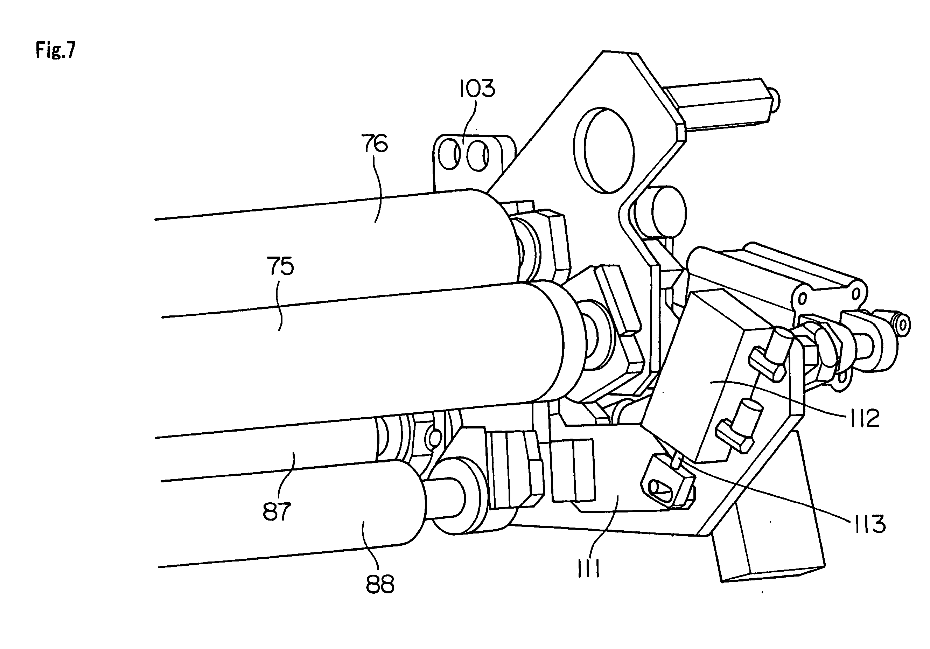

The bridge roller 88 is supported by a rocking arm 111 shown in Fig. 7. The rocking arm 111 is rockable about the axis of water applicator roller 87. The rocking arm 111 is connected to a cylinder rod 113 of an air cylinder 112. When the cylinder rod 113 of air cylinder 112 is extended, the bridge roller 88 is placed in a position for contacting one of the ink applicator rollers 59 described hereinafter, and supplying dampening water on the water applicator roller 87 to the ink feeder 20d. When the cylinder rod 113 of air cylinder 112 is retracted, the bridge roller 88 moves to a position separated from the ink applicator roller 59.

The three other dampening water feeders 21a, 21b and 21c have compositions similar to this dampening water feeder 21d. The dampening water feeders 21a and 21c have no metering roller 76. This is because the dampening water feeders 21a and 21c are arranged below the rotary shafts of plate cylinders 11 and 12, and dampening water can be transmitted only with the three rollers. Although the dampening water feeders 21a-21d include three or four dampening water rollers according to their locations, the basic construction and operation are the same.

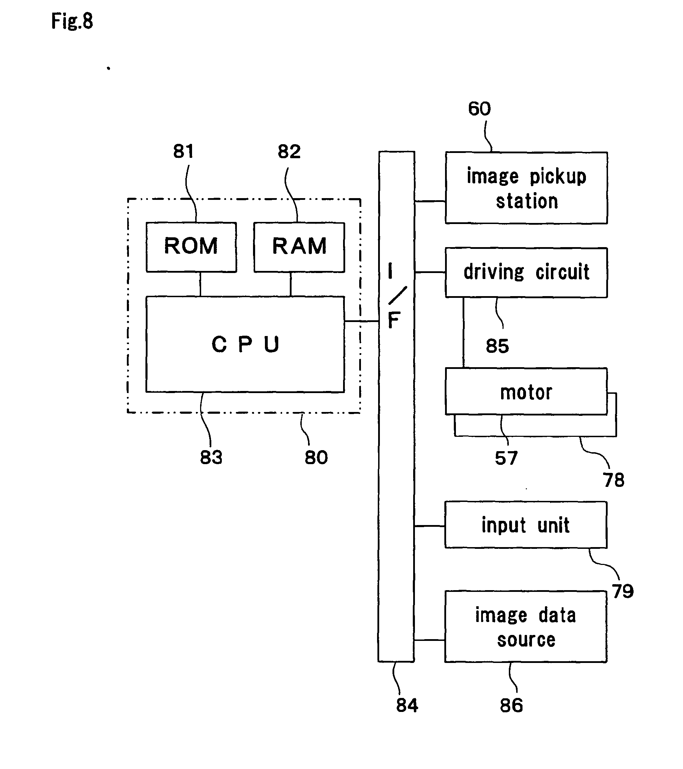

Fig. 8 is a block diagram showing a principal electrical structure of the printing machine. This printing machine includes a control unit 80 having a ROM 81 for storing operating programs necessary for controlling the machine, a RAM 82 for temporarily storing data and the like during a control operation, and a CPU 83 for performing logic operations. The control unit 80 has a driving circuit 85 connected thereto through an interface 84, for generating driving signals for driving the ink feeders 20, dampening water feeders 21, image recorders 35 and 36 and so on. The motor 57 of each ink feeder 20 and the motor 78 of each dampening water feeder 21 described hereinbefore are connected to the driving circuit 85. The control unit 80 is connected also to the image pickup station 60 and the input unit 79 through the interface 84. Further, the control unit 80 is connected to an image data source 86 storing image data for use in platemaking and printing. The printing machine, under control of this control unit 80 performs a prepress operation and a printing operation including ink and dampening water feeding to be described hereinafter.

The control unit 80 determines, based on the data received from the image data source 86, whether non-image areas can be removed, with ink, from the printing plates set to the printing machine. When non-image areas are found removable in this way, the control unit 80 sets the larger opening degree to the ink keys 54 for the smaller image percentage of the images recorded on the printing plates. When non-image areas are found irremovable with ink, the control unit 80 sets the larger opening degree to the ink keys 54 for the larger image percentage of the images recorded on the printing plates. Thus, the control unit 80 acts as the ink key opening degree setting device according to this invention. Further, while dampening water is fed to the printing plates by the dampening water feeders 21 before a printing operation, the control unit 80 executes a pre-inking operation for feeding ink to the printing plates based on a predetermined quantity of ink. Thus, the control unit 80 acts as the pre-inking operation executing device according to this invention.

In the printing machine having the above construction, a printing plate stock drawn from a supply cassette 41 of the plate feeder 33 is cut to a predetermined size by a cutter 42. The forward end of each plate in cut sheet form is guided by guide rollers and guide members, not shown, and is clamped by clamps of the first plate cylinder 11. Then, the first plate cylinder 11 is driven by a motor, not shown, to rotate at low speed, whereby the plate is wrapped around the peripheral surface of the first plate cylinder 11. The rear end of the plate is clamped by other clamps of the first plate cylinder 11. While, in this state, the first plate cylinder 11 is rotated at high speed, the image recorder 35 irradiates the surface of the plate mounted peripherally of the first plate cylinder 11 with a modulated laser beam for recording an image thereon.

Similarly, a printing plate stock drawn from a supply cassette 43 of the plate feeder 34 is cut to the predetermined size by a cutter 44. The forward end of each plate in cut sheet form is guided by guide rollers and guide members, not shown, and is clamped by clamps of the second plate cylinder 12. Then, the second plate cylinder 12 is driven by a motor, not shown, to rotate at low speed, whereby the plate is wrapped around the peripheral surface of the second plate cylinder 12. The rear end of the plate is clamped by other clamps of the second plate cylinder 12. While, in this state, the second plate cylinder 12 is rotated at high speed, the image recorder 36 irradiates the surface of the plate mounted peripherally of the second plate cylinder 12 with a modulated laser beam for recording an image thereon.

The first plate cylinder 11 has, mounted peripherally thereof, a plate for printing in black ink and a plate for printing in cyan ink. The two plates are arranged in evenly separated positions (i.e. in positions separated from each other by 180 degrees). The image recorder 35 records images on these plates. Similarly, the second plate cylinder 12 has, mounted peripherally thereof, a plate for printing in magenta ink and a plate for printing in yellow ink. The two plates also are arranged in evenly separated positions, and the image recorder 36 records images on these plates.

After the images are recorded, the plates are developed to complete the prepress process. This printing machine employs a developing method for removing non-image areas with the inks after placing the dampening water feed rollers in contact with the printing plates to soften the non-image areas with dampening water. This developing process will be described in detail hereinafter.

The prepress process is followed by a printing process for printing the printing paper with the plates mounted on the first and second plate cylinders 11 and 12. This printing process is carried out as follows.

First, each dampening water feeder 21 and each ink feeder 20 are placed in contact with only a corresponding one of the plates mounted on the first and second plate cylinders 11 and 12. Consequently, dampening water and inks are fed to the plates from the corresponding water feeders 21 and ink feeders 20, respectively. These inks are transferred from the plates to the corresponding regions of the first and second blanket cylinders 13 and 14, respectively.

Then, the printing paper is fed to the paper feed cylinder 17. The printing paper is subsequently passed from the paper feed cylinder 17 to the first impression cylinder 15. The impression cylinder 15 having received the printing paper continues to rotate. Since the first impression cylinder 15 has half the diameter of the first plate cylinder 11 and the first blanket cylinder 13, the black ink is transferred to the printing paper wrapped around the first impression cylinder 15 in its first rotation, and the cyan ink in its second rotation.

After the first impression cylinder 15 makes two rotations, the printing paper is passed from the first impression cylinder 15 to the second impression cylinder 16 through the transfer cylinder 18. The second impression cylinder 16 having received the printing paper continues to rotate. Since the second impression cylinder 16 has half the diameter of the second plate cylinder 12 and the second blanket cylinder 14, the magenta ink is transferred to the printing paper wrapped around the second impression cylinder 16 in its first rotation, and the yellow ink in its second rotation.

The forward end of the printing paper printed in the four colors in this way is passed from the second impression cylinder 16 to the paper discharge cylinder 19. The printing paper is transported by the pair of chains 23 toward the paper discharge station 32 to be discharged thereon.

After the printing process, the plates used for printing is discharged. The first and second blanket cylinders 13 and 14 are cleaned by a blanket cylinder cleaning device, not shown, to complete the printing process.

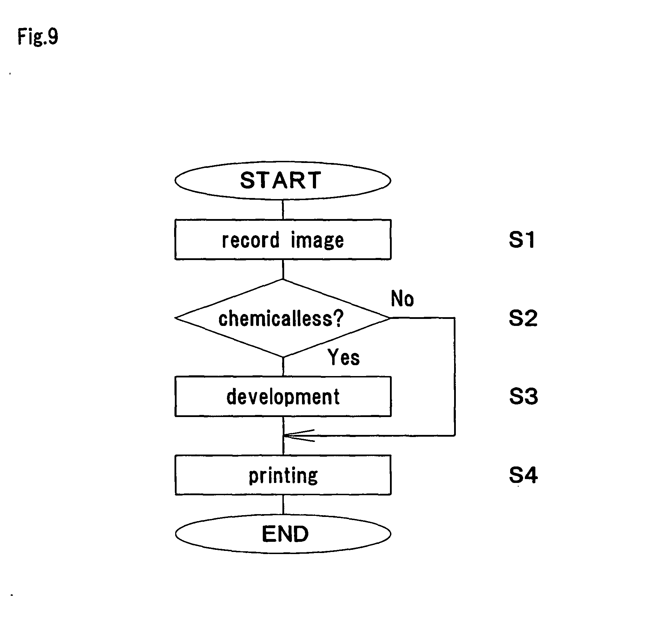

Next, the developing method which characterizes this invention will be described. A procedure of performing the developing method according to this invention will be described first. Fig. 9 is a flow chart showing a procedure of performing the developing method according to this invention as a pre-inking process before a printing operation.

This printing machine first records images in the prepress process as described above (step S1). This image recording is carried out by the image recorders 35 and 36 noted hereinbefore. When the plates having the images recorded thereon are chemicalless printing plates (step S2), the developing method according to this invention is carried out (step S3) and then printing is carried out (step S4). When the plates having the image recorded thereon are not chemicalless printing plates, but ordinary printing plates (what are called PS plates or the like) or printing plates not needing development (e.g. ablation type printing plates) (step S2), an ordinary pre-inking suited for the plates is carried out, and then printing is performed (step S4). In an ordinary pre-inking process, the larger ink key opening degree is set for the larger image percentage (conventional setting of ink key opening) before a printing process, i.e. before feeding printing paper, and in the state the inks are supplied to the ink rollers to ink the surfaces of the plates beforehand.

As a method of determining in step S2 whether the printing plates are chemicalless or not, the operator inputs the type of printing plates to be used as data to the control unit 80 beforehand. In this case, the control unit 80 acts as a determining device for determining the type of printing plates set to the printing machine from the data inputted through an input unit 79. However, instead of inputting the data, the type of printing plates may be determined by detecting the type of supply cassettes 41 and 43 storing the printing plate stocks.

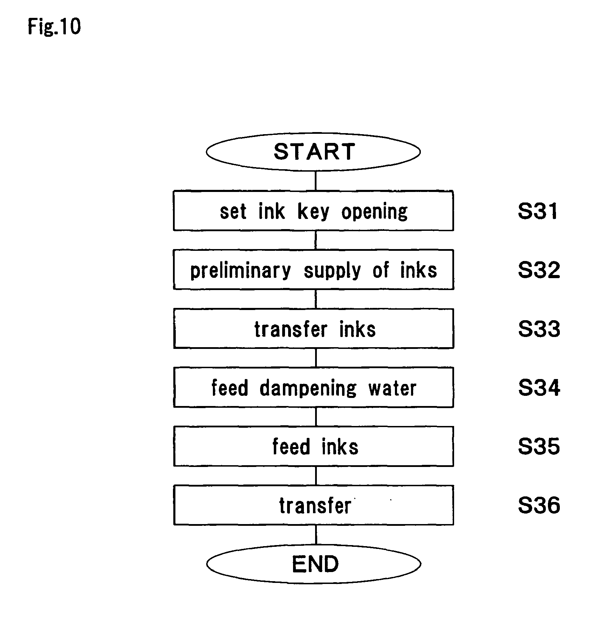

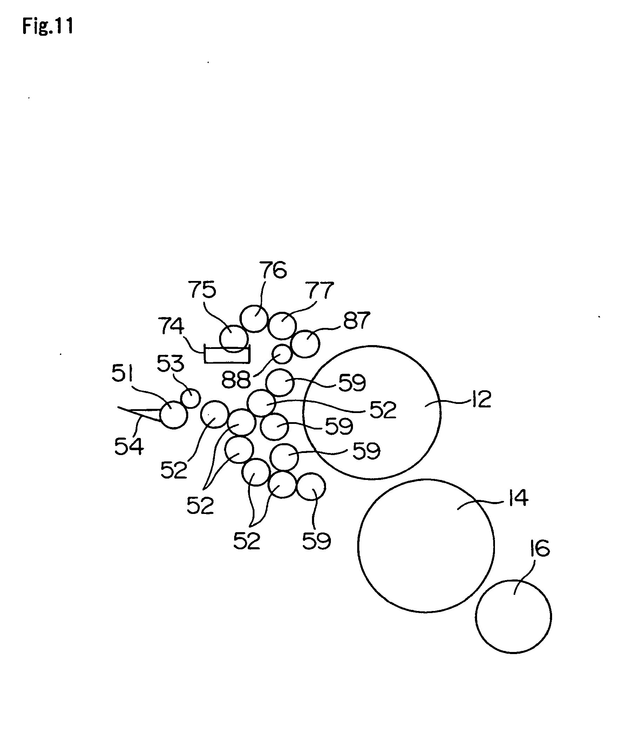

Next, the developing method according to this invention will be described. Fig. 10 is a flow chart showing the developing method according to this invention. Figs. 11 through 14 are schematic views showing a developing operation according to this invention. In Figs. 11 through 14, the developing operation uses the ink feeder 20d and dampening water feeder 21d. Developing operations using the other ink feeders 20a, 20b and 20c and dampening water feeders 21a, 21b and 21c are the same.

When performing a developing process according to this invention, an ink key opening degree setting step is executed first for setting opening degrees of the ink keys 54 in each ink feeder 20 (step S31). At this time, the larger opening degree is set to each ink key 54 in each ink feeder 20 for the smaller image percentage in the region of the printing plate corresponding to that ink key.

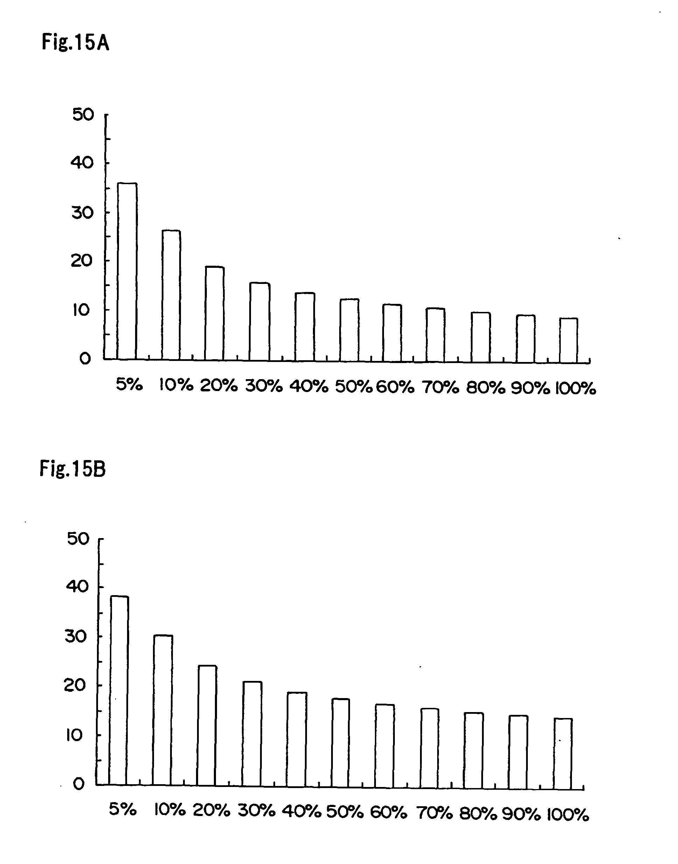

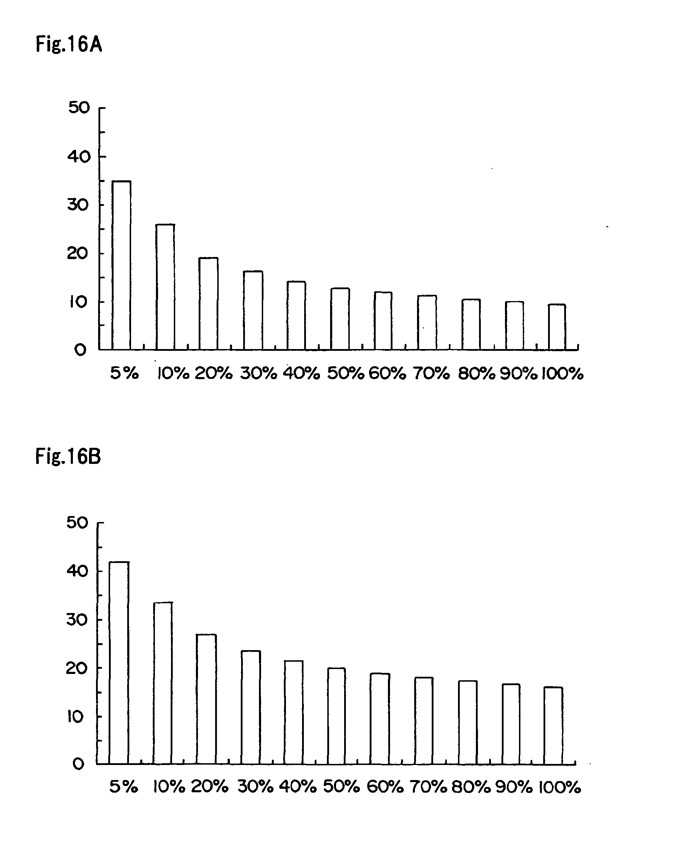

Figs. 15 and 16 are graphs showing a relationship between image percentage and opening degree of each ink key. Fig. 15A shows the case of cyan ink, Fig. 15B magenta ink, Fig. 16A yellow ink, and Fig. 16B black ink.

In these figures, the horizontal axis represents the image percentages (%), and the vertical axis the opening degrees (%) of ink keys 54. As shown in these figures, the larger opening degree is set to each ink key 54 for the smaller image percentage. The relationship between image percentage and opening degree of ink keys 54 is different for each color ink because each color ink is different in composition, tack value, water content and so on. Thus, these graphs differ from ink to ink. To obtain these data, development is carried out experimentally while gradually changing ink key opening degrees, for example. After a predetermined developing operation, the operator visually checks non-image areas that remain, thereby to determine required ink key opening degrees. Such data are stored beforehand in the RAM 82 of the control unit 80 shown in Fig. 8, for the different inks to be used.

The larger opening degree is set to each ink key 54 for the smaller image percentage for the following reason. In time of printing, the larger opening degree is set to each ink key 54 for the region of the larger image percentage. Conventionally, in time of development, the opening degree of each ink key is the same as in time of printing, or development is carried out with the same opening degree for all ink keys. However, in time of development, non-image areas are removed as eluted or mixed with ink, and the larger non-image area requires the larger quantity of ink to be used for removal. It is therefore necessary to set the larger opening degree to each ink key 54 for the larger non-image area. To put this conversely, the larger opening degree is set to ink key 54 for the smaller image percentage.

That is, a predetermined quantity of ink is supplied according to an image percentage, to each of the regions, L in number, corresponding to the ink keys 54, L in number, of each ink feeder 20.

Next, a preliminary ink supplying step is executed for supplying the inks to the ink rollers (step S32). In this state, as shown in Fig. 11, each ink applicator roller 59 is placed in a position separated from the printing plate on the first plate cylinder 11 or second plate cylinder 12. Then, the ink transfer roller 53 performs an ink fetching operation to reciprocate between the ink source roller 51 and ink carrier rollers 52. As a result, the ink is supplied to the ink rollers as a preliminary step. Based on the ink key opening degrees set in step S31, the ink is supplied at this time in the larger quantity to the region of the smaller image percentage.

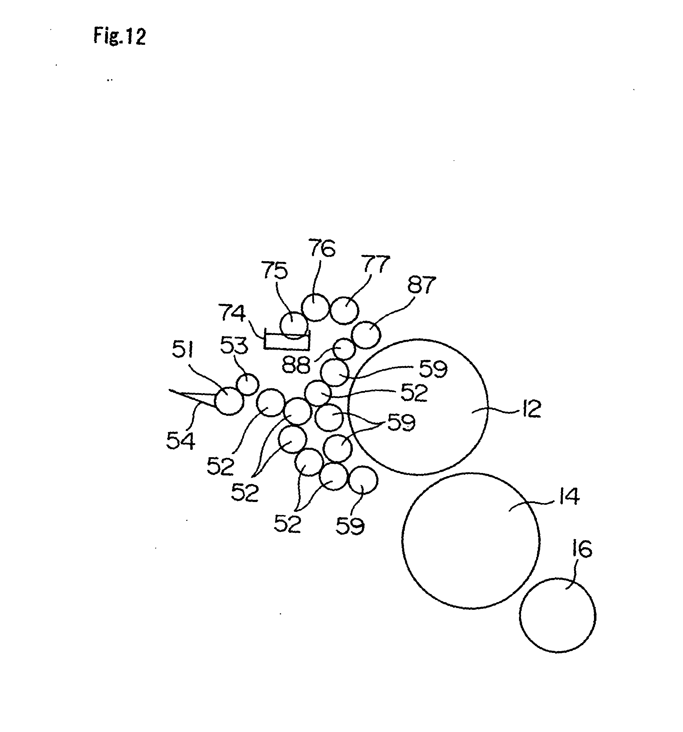

Next, at step S33, an ink transfer step is executed for transferring the ink from the ink rollers to the dampening water rollers. Specifically, as shown in Fig. 12, the bridge roller 88 of the dampening water feeder 21 is moved to the position for contacting one ink applicator roller 59 of the ink feeder, and is rotated a predetermined number of times. Dampening water has been supplied to the water applicator roller 87 in advance. In this step S33, the water applicator roller 87 is separated from the intermediate roller 77, and no new dampening water is supplied to the water applicator roller 87.

When the water applicator roller 87 and ink applicator roller 59 are connected through the bridge roller 88 in this way, the ink is transferred from the ink applicator roller 59 to the water applicator roller 87. Consequently, emulsified ink mixed with dampening water is present on the water applicator roller 87. In this state, the ink transfer roller 53 is suspended from a new ink fetching operation. As a result of the above operation, the ink rollers and water applicator roller 87 will have an ink profile with the larger ink film thickness formed for the region of the smaller image percentage.

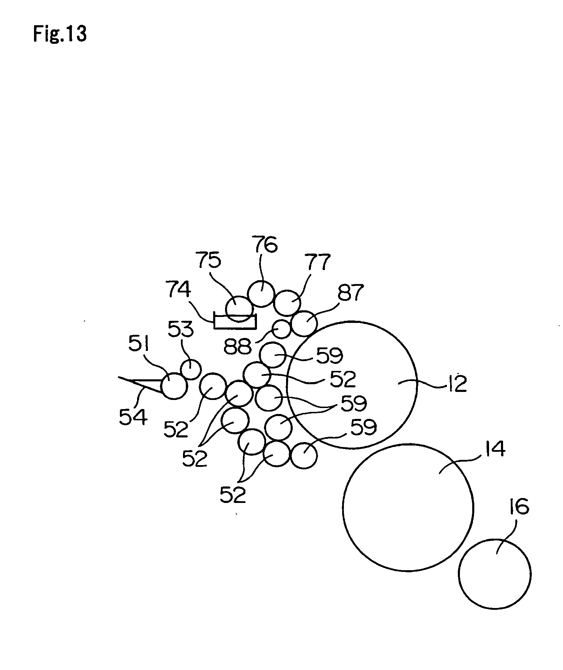

Next, a dampening water feeding step is executed for causing the dampening water rollers to feed dampening water to the printing plate (step S34). Specifically, as shown in Fig. 13, with the water fountain roller 75, metering roller 76, intermediate roller 77, water applicator roller 87 and bridge roller 88 placed in contact with each other, the water applicator roller 87 is moved into contact with the surface of the printing plate mounted on the first or second plate cylinder 11 or 12 to supply the dampening water on the dampening water rollers to the printing plate.

This dampening water feeding step includes a first dampening water feeding step for feeding a larger quantity of dampening water than an ordinary quantity of dampening water, and a second dampening water feeding step for feeding a smaller quantity of dampening water than the first dampening water feeding step.

That is, the water fountain roller 75 is first rotated at about twice a usual speed of rotation by the motor 78 shown in Fig. 4, to feed a large quantity of dampening water to the dampening water rollers, and on to the printing plate. Subsequently, the water fountain roller 75 is rotated at the usual speed to feed dampening water in a quantity similar to the proper quantity in time of printing, to the printing plate through the dampening water rollers. As a result, the ink supplied to the water applicator roller 87 in the previous ink transfer step and now super-emulsified, and a large quantity of dampening water, are effectively supplied to the printing plate not supplied with dampening water yet.

It has been found through experiment conducted by Applicant that a large quantity of dampening water produces a desirable effect in an initial state of development, and that excellent developing efficiency is realized particularly by use of emulsified ink formed by mixture of dampening water and ink. In this dampening water feeding step, the dampening water supplied in a large quantity softens the surface of the printing plate to be removable with ease. The super- emulsified ink adhering to the water applicator roller 87 starts removing non-image areas.

The reason that the dampening water supplied as mixed with ink in the early stage of development gives excellent results of development is probably because the surfaces of non-image areas have lipophilic properties also.

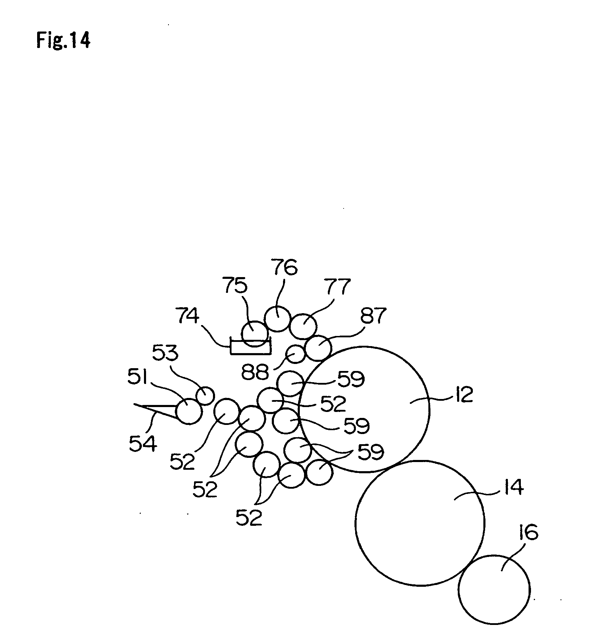

Then, in parallel with the above dampening water feeding, an ink feeding step is executed for feeding ink to the printing plate with the ink rollers (step S35). Specifically, as shown in Fig. 14, each ink applicator roller 59 is placed in contact with the printing plate mounted peripherally of the first or second plate cylinder 11 or 12 to supply ink to the plate surface. As a result, regions to form non-image areas on the printing plate are removed from the plate surface with the ink, and are partly transferred back to the ink rollers. The ink transfer roller 53 is suspended from the ink fetching operation at this time.

Subsequently, a transfer step is executed for transferring the ink from the printing plate to printing paper (step S36). Specifically, as shown in Fig. 14, the second plate cylinder 12, second blanket cylinder 14 and second impression cylinder 16 are moved into contact with one another. Similarly, the first plate cylinder 11, first blanket cylinder 13 and first impression cylinder 15 are moved into contact. Printing paper to be wasted is fed from the paper storage station 31, and unwanted ink used in removing the non-image areas from the printing plate is transferred to the printing paper. This completes the development of the printing plate.

After the development of the printing plate is completed, the opening degrees of the ink keys 54 in each ink feeder 20 are changed to the usual state where the larger opening degree is set to the ink key for the region of the larger image percentage, to be ready for the printing process that follows. The opening degrees of the ink keys may be returned to the usual state before step S35 or step S36. That is, the opening degrees of the ink keys may be returned to the usual state after the ink profile for developments is once formed in step S32.

In the embodiment described above, this invention is applied to the printing machine that performs a printing operation after recording images on printing plates. This invention may be applied to a printing machine that performs a printing operation only.

In the embodiment described above, as shown in Fig. 9, the invention is applied to the printing machine that uses both usual printing plates and chemicalless printing plates. This invention may be applied to a printing machine that uses only chemicalless printing plates.

## Claims

1. A printing plate developing method for removing non-image areas from a printing plate having an image recorded thereon, by using a printing machine having ink rollers (51, 52, 53, 59) for feeding ink to a surface of the printing plate, and a dampening water feeding device (21) for feeding dampening water to the surface of the printing plate, said developing method being **characterized by**:
an ink key opening degree setting step for setting opening degrees of ink keys (54) for feeding the ink to said ink rollers (51, 52, 53, 59), such that the larger opening degree is set for the smaller image percentage in regions, corresponding to the respective ink keys (54), on the printing plate having the image recorded thereon;
a dampening water feeding step for feeding the dampening water to the printing plate with said dampening water feeding device (21a, 21b, 21c, 21d) to render the non-image areas on the printing plate easily removable;
an ink feeding step for feeding the ink to the printing plate with said ink rollers (51, 52, 53, 59) based on the ink key opening degrees set in said ink key opening degree setting step, to remove the non-image areas; and
a transfer step for transferring the ink used to remove the non-image areas, from the printing plate to printing paper.

2. A printing plate developing method according to claim 1, comprising:
an image recording step for recording the image on the printing plate with an image recorder (35, 36); and, between said opening degree setting step and said dampening water feeding step:
a preliminary ink feeding step for feeding the ink to said ink rollers (51, 52, 53, 59);
an ink transfer step for transferring the ink from said ink rollers (51, 52, 53, 59) to dampening water rollers of said dampening water feeding device (21a, 21b, 21c, 21d).

3. A printing plate developing method as defined in claim 2, wherein said preliminary ink feeding step is executed to feed the ink to said ink rollers (51, 52, 53, 59), with the opening degrees of the ink keys (54) set in said ink key opening degree setting step.

4. A printing plate developing method as defined in claim 1 or 2, wherein said dampening water feeding step includes a first dampening water feeding step for feeding a larger quantity of dampening water than a usual quantity of dampening water, and a second dampening water feeding step for feeding a smaller quantity of dampening water than said first dampening water feeding step.

5. A printing machine having an ink roller (51, 52, 53, 59) for feeding ink to a surface of a printing plate, ink keys (54) capable of feeding desired quantities of ink to a plurality of regions on said ink roller (51, 52, 53, 59), and a dampening water feeding device for feeding dampening water to the surface of the printing plate, said printing machine being **characterized by**:
an input device (79) adapted to input information indicating whether said printing plate is a first printing plate that permits non-image areas to be removed therefrom with the ink, or a second printing plate that prohibits non-image areas from being removed with the ink;
an ink key opening degree setting device adapted to set the larger opening degree of said ink keys (54) for the smaller image percentage of an image recorded on the printing plate when the printing plate set to the printing machine is said first printing plate, and to set the larger opening degree of said ink keys (54) for the larger image percentage of the image recorded on the printing plate when the printing plate set to the printing machine is said second printing plate; and
a pre-inking operation executing device adapted to execute a pre-inking operation for feeding the ink to the printing plate based on an ink quantity set by said ink key opening degree setting device and to concurrently feed dampening water to the printing plate by the dampening water feeding device before a printing operation.

6. A printing machine as defined in claim 5, wherein, when the printing plate is said first printing plate, the pre-inking operation executing device is adapted to perform the pre-inking operation first with opening degrees of said ink keys (54) set such that the smaller the image percentage of the image recorded on the printing plate the larger the opening degree is, and then to continue the pre-inking operation with the opening degrees of said ink keys (54) changed such that the larger the image percentage of the image recorded on the printing plate the larger the opening degree is.

7. A printing machine as defined in claim 6, wherein said dampening water feeding device includes a water applicator roller (87) for feeding the dampening water to the surface of the printing plate, and a bridge roller (88) bridging said water applicator roller (87) and said ink roller (51, 52, 53, 59) for forming an ink profile on said water applicator roller (87) before said pre-inking operation.

## Patentansprüche

1. Druckplattenentwicklungsverfahren zur Entfernung von Bildlosbereichen von einer Druckplatte, auf der ein Bild aufgezeichnet ist, unter Verwendung einer Druckmaschine mit Farbwalzen (51, 52, 53, 59) zum Zuführen von Farbe auf eine Oberfläche der Druckplatte sowie mit einer Befeuchtungswasserzuführvorrichtung (21) zum Zuführen von Befeuchtungswasser auf die Oberfläche der Druckplatte, wobei das Entwicklungsverfahren **gekennzeichnet ist durch**
einen Farbzonenschraubenöffnungsgradeinstellschritt zum Einstellen des Öffnungsgrades von Farbzonenschrauben (54) zum Zuführen der Farbe auf die Farbwalzen (51, 52, 53, 59), derart, dass der größere Öffnungsgrad für den kleineren Bildprozentsatz in Bereichen, die den betreffenden Farbzonenschrauben (54) entsprechen, auf der Druckplatte mit dem darauf aufgezeichneten Bild eingestellt wird;
einen Befeuchtungswasserzuführschritt zum Zuführen des Befeuchtungswassers auf die Druckplatte mit der Befeuchtungswasserzuführvorrichtung (21a, 21b, 21c, 21d), um die Bildlosbereiche auf der Druckplatte leicht entfernbar zu machen;
einen Farbzuführschritt zum Zuführen der Farbe auf die Druckplatte mit den Farbwalzen (51, 52, 53, 59), beruhend auf den im Farbzonenschraubenöfnungsgradeinstellschritt eingestellten Farbzonenschraubenöffnungsgraden; und
einen Übertragungsschritt zum Übertragen der zur Entfernung der Bildlosbereiche verwendeten Farbe von der Druckplatte auf Druckpapier.

2. Druckplattenentwicklungsverfahren nach Anspruch 1, welches aufweist:
einen Bildaufzeichnungsschritt zum Aufzeichnen des Bildes auf der Druckplatte mit einem Bildaufzeichnungsgerät (35, 36) und, zwischen dem Öffnungsgradeinstellschritt und dem Befeuchtungswasserzuführschritt:
einen vorausgehenden Farbzuführschritt zum Zuführen der Farbe auf die Farbwalzen (51, 52, 53, 59);
einen Farbübertragungsschritt zum Übertragen der Farbe von den Farbwalzen (51, 52, 53, 59) auf Befeuchtungswasserwalzen der Befeuchtungswasserzuführvorrichtung (21a, 21b, 21c, 21d).

3. Druckplattenentwicklungsverfahren nach Anspruch 2, wobei der vorausgehende Farbzuführschritt zum Zuführen der Farbe auf die Farbwalze (51, 52, 53, 59) mit den im Farbzonenschraubenöffnungsgradeinstellschritt eingestellte Öffnungsgraden der Farbzonenschrauben (54) ausgeführt wird.

4. Druckplattenentwicklungsverfahren nach Anspruch 1 oder 2, wobei der Befeuchtungswasserzuführschritt einen ersten Befeuchtungswasserzuführschritt zum Zuführen einer größeren Menge an Befeuchtungswasser, als es eine übliche Menge an Befeuchtungswasser ist, und einen zweiten Befeuchtungswasserzuführschritt zum Zuführen einer kleineren Menge an Befeuchtungswasser als im ersten Befeuchtungswasserzuführschritt enthält.

5. Druckmaschine mit einer Farbwalze (51, 52, 53, 59) zum Zuführen von Farbe auf eine Oberfläche einer Druckplatte, mit Farbzonenschrauben (54), die gewünschte Mengen an Farbe einer Anzahl von Bereichen auf der Farbwalze (51, 52, 53, 59) zuführen können, und eine Befeuchtungswasserzuführvorrichtung zum Zuführen von Befeuchtungswasser zur Oberfläche der Druckplatte, wobei die Druckmaschine **gekennzeichnet ist durch**
eine Eingabevorrichtung (79) die zur Eingabe von Information eingerichtet ist, die angibt, ob die Druckplatte eine erste Druckplatte ist, die gestattet, dass Bildlosbereiche von dieser mit der Farbe entfernt werden, oder eine zweite Druckplatte, die ein Entfernen von Bildlosbereichen mit der Farbe verhindert;
eine Farbzonenöffnungsgradeinstellvorrichtung, die so eingerichtet ist, dass sie den größeren Öffnungsgrad der Farbzonenschrauben (54) für den kleineren Bildprozentsatz eines auf der Druckplatte aufgezeichneten Bilds einstellt, wenn die in der Druckmaschine angebrachte Druckplatte die erste Druckplatte ist, und sie den größeren Öffnungsgrad der Farbzonenschrauben (54) für den größeren Bildprozentsatz des auf der Druckplatte aufgezeichneten Bilds einstellt, wenn die in der Druckmaschine angebrachte Druckplatte die zweite Druckplatte ist;
eine Voreinfärbungsausführvorrichtung, die so ausgerichtet ist, dass sie eine Voreinfärbung zum Zuführen der Farbe auf die Druckplatte beruhend auf einer **durch** die Farbzonenschraubenöffnungsgradeinstellvorrichtung eingestellten Farbmenge ausführt und gleichzeitig Befeuchtungswasser der Druckplatte mit der Befeuchtungswasserzuführvorrichtung vor einem Druckvorgang zuführt.

6. Druckmaschine nach Anspruch 5, wobei, wenn die Druckplatte die erste Druckplatte ist, die Voreinfarbungsausführvorrichtung so eingerichtet ist, dass sie die Voreinfärbung zunächst mit Öffnungsgraden der Farbzonenschrauben (54) durchführt, die so eingestellt sind, dass umso kleiner der Bildprozentsatz des auf der Druckplatte aufgezeichneten Bildes ist, desto größer der Öffnungsgrad ist, und sie danach die Voreinfärbung mit Öffnungsgraden der Farbzonenschrauben (54) fortführt, die so geändert sind, dass umso größer der Bildprozentsatz des aufgezeichneten Bildes auf der Druckplatte ist, desto größer der Öffnungsgrad ist.

7. Druckmaschine nach Anspruch 6, wobei die Befeuchtungwasserzuführvorrichtung eine Wasserapplikationswalze (87) zum Zuführen des Befeuchtungswassers auf die Oberfläche der Druckplatte sowie eine Brückenwalze (88) zur Überbrückung von der Wasserapplikationswalze (87) zur Farbwalze (51, 52, 53, 59) zur Ausbildung eines Farbprofils auf der Wasserapplikationswalze (87) vor dem Voreinfärbungsvorgang enthält.

## Revendications

1. Procédé de développement de plaque d'impression pour retirer des zones de non image d'une plaque d'impression sur laquelle une image est enregistrée, par l'utilisation d'une machine d'impression comportant des rouleaux encreurs (51, 52, 53, 59) pour alimenter en encre une surface de la plaque d'impression, et un dispositif d'alimentation en eau de mouillage (21) pour alimenter en eau de mouillage la surface de la plaque d'impression, ledit procédé de développement étant
**caractérisé par** :
une étape de détermination de degré d'ouverture de touche d'encrage pour déterminer les degrés d'ouverture de touches d'encrage (54) pour alimenter en encre lesdits rouleaux d'encrage (51, 52, 53, 59), de sorte que le plus grand degré d'ouverture soit déterminé pour le plus petit pourcentage d'image dans des régions, correspondant aux touches d'encrage (54) respectives, sur la plaque d'impression sur lesquelles l'image est enregistrée ;
une étape d'alimentation en eau de mouillage pour alimenter en eau de mouillage la plaque d'impression au moyen dudit dispositif d'alimentation en eau de mouillage (21a, 21b, 21c, 21d) pour faciliter le retrait des zones de non image sur la plaque d'impression ;
une étape d'alimentation en encre pour alimenter en encre la plaque d'impression au moyen desdits rouleaux encreurs (51, 52, 53, 59) sur la base des degrés d'ouverture de touches d'encrage déterminés au cours de ladite étape de détermination de degré d'ouverture de touche d'encrage, pour retirer les zones de non image ; et
une étape de transfert pour transférer l'encre utilisée pour retirer les zones de non image, de la plaque d'impression à un papier d'impression.

2. Procédé de développement de plaque d'impression selon la revendication 1, comprenant :
une étape d'enregistrement d'image pour enregistrer l'image sur la plaque d'impression au moyen d'un enregistreur d'image (35, 36) ; et, entre ladite étape de détermination de degré d'ouverture et ladite étape d'alimentation en eau de mouillage :
une étape d'alimentation en encre préliminaire pour alimenter en encre lesdits rouleaux encreurs (51, 52, 53, 59) ;
une étape de transfert d'encre pour transférer l'encre desdits rouleaux encreurs (51, 52, 53, 59) aux rouleaux de mouillage dudit dispositif d'alimentation en eau de mouillage (21a, 21b, 21c, 21d).

3. Procédé de développement de plaque d'impression selon la revendication 2, dans lequel ladite étape d'alimentation en encre préliminaire est exécutée pour alimenter en encre lesdits rouleaux encreurs (51, 52, 53, 59), avec les degrés d'ouverture des touches d'encrage (54) déterminés au cours de ladite étape de détermination de degré d'ouverture de touche d'encrage.

4. Procédé de développement de plaque d'impression selon la revendication 1 ou 2, dans lequel ladite étape d'alimentation en eau de mouillage comprend une première étape d'alimentation en eau de mouillage pour délivrer une quantité d'eau de mouillage plus grande qu'une quantité habituelle d'eau de mouillage, et une seconde étape d'alimentation en eau de mouillage pour délivrer une plus petite quantité d'eau de mouillage qu'à ladite première étape d'alimentation en eau de mouillage.

5. Machine d'impression comportant un rouleau encreur (51, 52, 53, 59) pour alimenter en encre une surface d'une plaque d'impression, des touches d'encrage (54) capables de délivrer des quantités souhaitées d'encre à une pluralité de régions sur ledit rouleau encreur (51, 52, 53, 59), et un dispositif d'alimentation en eau de mouillage pour alimenter en eau de mouillage la surface de la plaque d'impression, ladite machine d'impression étant **caractérisée par** :
un dispositif d'entrée (79) adapté pour entrer des informations indiquant si ladite plaque d'impression est une première plaque d'impression qui permet le retrait de zones de non image de celle-ci au moyen de l'encre, ou une seconde plaque d'impression qui empêche le retrait de zones de non image au moyen de l'encre ;
une dispositif de détermination de degré d'ouverture de touche d'encrage adapté pour déterminer le plus grand degré d'ouverture desdites touches d'encrage (54) pour le plus petit pourcentage d'image d'une image enregistrée sur la plaque d'impression lorsque la plaque d'impression placée sur la machine d'impression est ladite première plaque d'impression, et pour déterminer le plus grand degré d'ouverture desdites touches d'encrage (54) pour le plus grand pourcentage d'image de l'image enregistrée sur la plaque d'impression lorsque la plaque d'impression placée sur la machine d'impression est ladite seconde plaque d'impression ; et
un dispositif d'exécution d'opération de préencrage adapté pour exécuter une opération de préencrage pour alimenter en encre la plaque d'impression sur la base d'une quantité d'encre déterminée par ledit dispositif de détermination de degré d'ouverture de touche d'encrage et pour, simultanément, alimenter en eau de mouillage la plaque d'impression par le dispositif d'alimentation en eau de mouillage avant une opération d'impression.

6. Machine d'impression selon la revendication 5, dans laquelle, lorsque la plaque d'impression est ladite première plaque d'impression, le dispositif d'exécution d'opération de préencrage est adapté pour effectuer l'opération de préencrage d'abord avec les degrés d'ouverture desdites touches d'encrage (54) déterminés de sorte que, plus le pourcentage d'image de l'image enregistrée sur la plaque d'impression est petit, plus le degré d'ouverture est grand, et ensuite pour poursuivre l'opération de préencrage avec les degrés d'ouverture desdites touches d'encrage (54) modifiés de sorte que, plus le pourcentage d'image de l'image enregistrée sur la plaque d'impression est grand, plus le degré d'ouverture est grand.

7. Machine d'impression selon la revendication 6, dans laquelle ledit dispositif d'alimentation en eau de mouillage comprend un rouleau applicateur d'eau (87) pour alimenter en eau de mouillage la surface de la plaque d'impression, et un rouleau formant point (88) formant un pont entre ledit rouleau applicateur d'eau (87) et ledit rouleau encreur (51, 52, 53, 59) pour former un profil d'encre sur ledit rouleau applicateur d'eau (87) avant ladite opération de préencrage.
